# EUROPÄISCHE PATENTSCHRIFT

(11) **EP 0 958 621 B1**
(45) Veröffentlichungstag und Bekanntmachung des Hinweises auf die Patenterteilung: **01.10.2003**
(21) Anmeldenummer: 98947362.4
(22) Anmeldetag: 29.07.1998
(51) Int. Cl.: H01L 43/04, H02K 29/08

(54) **BAUTEILHALTER FÜR EINEN HALL-SENSOR UND VERFAHREN ZUM HERSTELLEN EINES BAUTEILHALTERS**
COMPONENT HOLDER FOR A HALL SENSOR AND PROCESS FOR PRODUCING A COMPONENT HOLDER
PORTE-COMPOSANT POUR CAPTEUR HALL, ET PROCEDE DE PRODUCTION

(30) Priorität: 06.11.1997 DE 19748982
(43) Veröffentlichungstag der Anmeldung: 24.11.1999
(73) Patentinhaber: ROBERT BOSCH GMBH, 70442 Stuttgart (DE)
(72) Erfinder: RIEHL, Günther, D-77830 Bühlertal (DE); HAGER, Martin, D-77830 Bühlertal (DE)
(86) Internationale Anmeldenummer: DE9802142
(87) Internationale Veröffentlichungsnummer: WO99025034

(56) Entgegenhaltungen:
- EP-A- 0 547 935
- EP-A- 0 786 856
- US-A- 4 482 849
- US-A- 4 939 499
- PATENT ABSTRACTS OF JAPAN vol. 096, no. 012, 26. Dezember 1996 & JP 08 223893 A (SHIBAURA ENG WORKS CO LTD), 30. August 1996

## Beschreibung

### Stand der Technik

Die Erfindung geht aus von einem Bauteilhalter für einen Hall-Sensor nach der Gattung des Anspruchs 1 bzw. 2 und von einem Verfahren zum Herstellen eines Bauteilhalters nach der Gattung des Anspruchs 9. Es ist bereits ein Bauteilhalter für einen Hall-Sensor bekannt (DE-OS 32 35 204), der über den Hall-Sensor gestülpt wird, um diesen nach allen Seiten hin zu halten, so daß eine Positionierung des Hall-Sensors auf einer Leiterplatte in einem engen radialen Toleranzbereich zu einem umlaufenden Magnetring möglich ist. Der Bauteilhalter verfügt über angespritzte Zentrierzapfen, die in entsprechende Öffnungen der Leiterplatte eingeführt werden können. Zur Montage des Hall-Sensors wird der Hall-Sensor zunächst mit seinen Anschlußbeinchen in Öffnungen der Leiterplatte eingesteckt und anschließend wird der Bauteilhalter darübergestülpt, bis er mit seiner Unterfläche an der Oberfläche der Leiterplatte anstößt. Diese Art der Montage von Hall-Sensor und Bauteilhalter auf der Leiterplatte ist jedoch aufwendig. Außerdem läßt sich durch das Überstülpen des Bauteilhalters kein spielfreier Sitz des Hall-Sensors in dem Bauteilhalter bewerkstelligen. Ohne einen spielfreien Sitz ist es aber nur schwer möglich, mit hoher Genauigkeit die Drehlage eines zu detektierenden Rotors eines Verstellmotors zu bestimmen. Des weiteren ist der aus dem Stand der Technik bekannte Bauteilhalter für eine automatische Bestückung in Massenherstellung mittels Bestückungsautomaten nicht geeignet.

### Vorteile der Erfindung

Der erfindungsgemäße Bauteilhalter mit den kennzeichnenden Merkmalen des Anspruchs 1 bzw. 2 sowie das Verfahren zum Herstellen eines Bauteilhalters nach Anspruch 9 hat demgegenüber den Vorteil, daß eine spielfreie Verbindung des Hall-Sensors im Bauteilhalter erfolgt, wodurch sich der Hall-Sensor mit hoher Präzision zu einem Magnetring auf einer Leiterplatte befestigen läßt. Besonders vorteilhaft ist außerdem, daß durch den erfindungsgemäßen Bauteilhalter eine automatische Bestückung der Leiterplatte mittels Bestückungsautomaten in Massenherstellung möglich ist, so daß sich die Montagekosten verringern.

Durch die in den Unteransprüchen aufgeführten Maßnahmen sind vorteilhafte Weiterbildungen und Verbesserungen des im Anspruch 1 bzw. 2 angegebenen Bauteilhalters sowie des im Anspruch 9 angegebenen Verfahrens möglich.

### Zeichnung

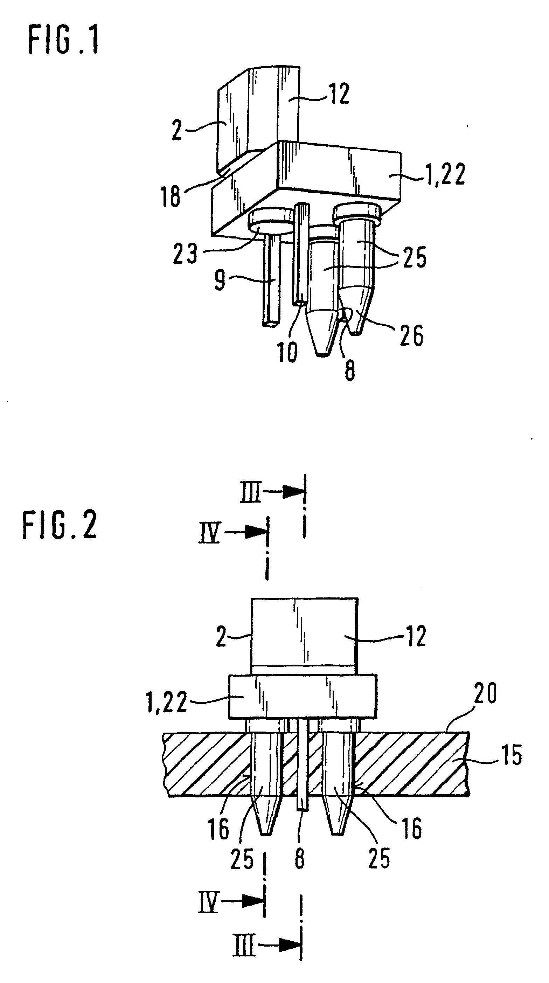

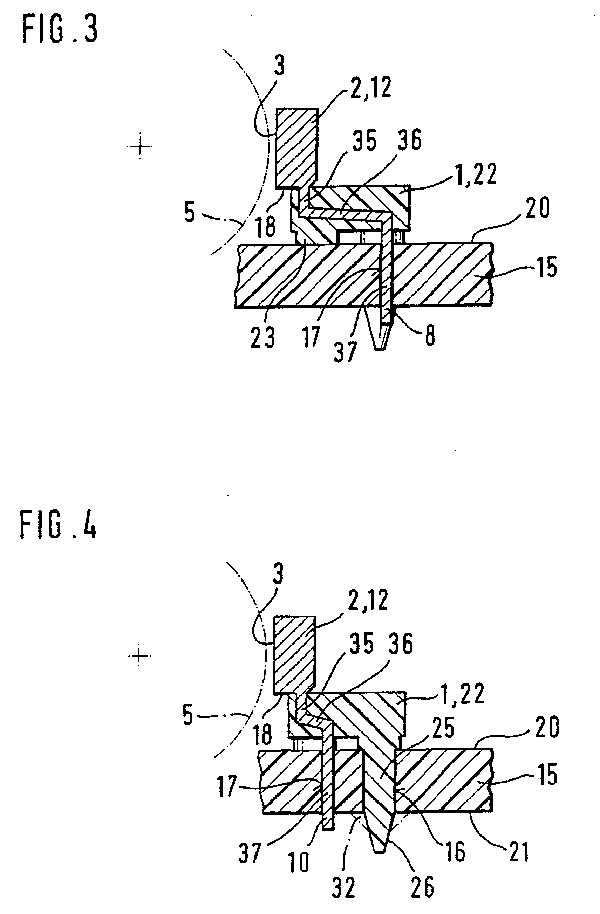

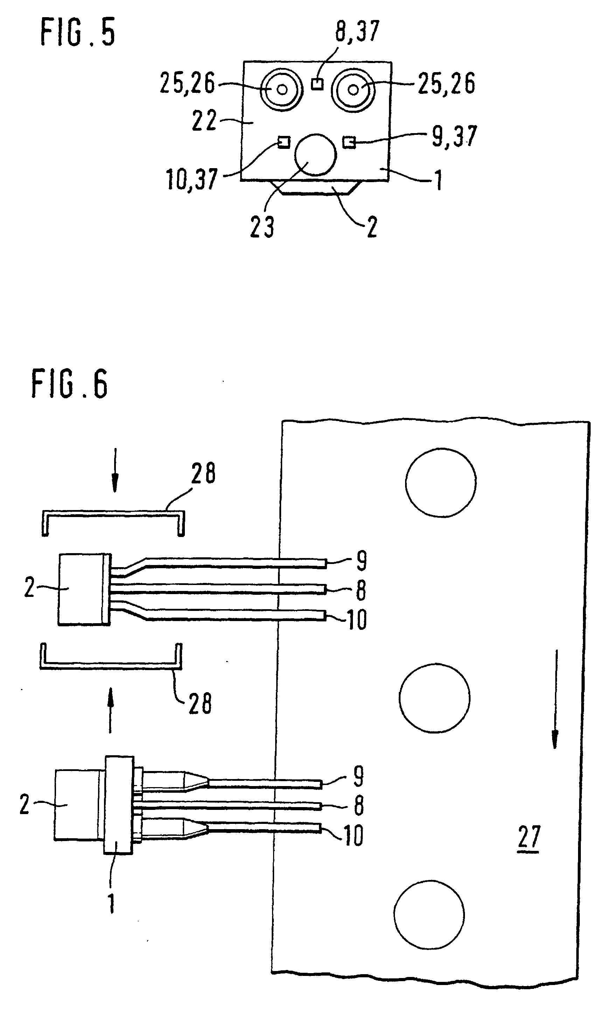

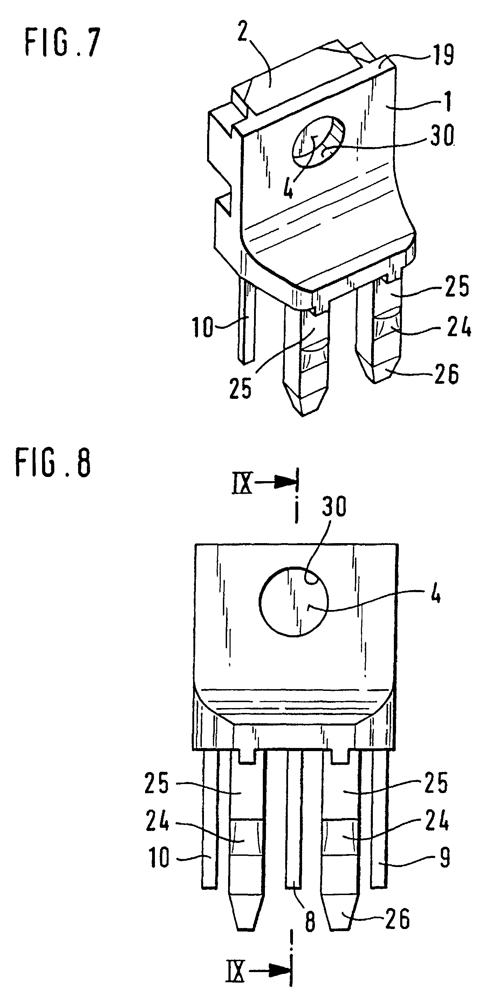

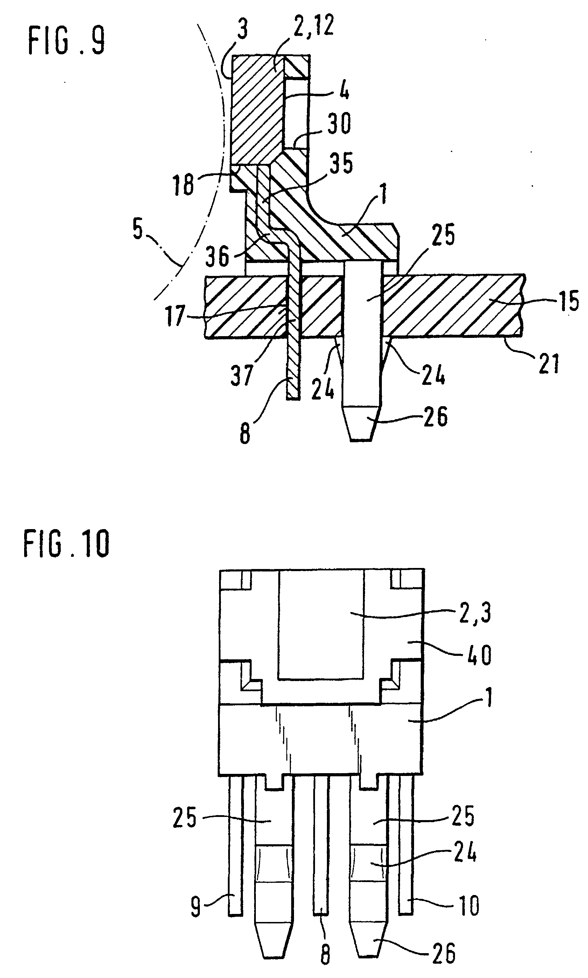

Ausführungsbeispiele der Erfindung sind in der Zeichnung vereinfacht dargestellt und in der nachfolgenden Beschreibung näher erläutert. Es zeigen Figur 1 eine perspektivische Darstellung eines Bauteilhalters mit Hall-Sensor nach einem ersten erfindungsgemäßen Ausführungsbeispiel, Figur 2 eine Vorderansicht des erfindungsgemäßen Bauteilhalters mit Hall-Sensor nach Figur 1, Figur 3 einen Schnitt durch den erfindungsgemäßen Bauteilhalter mit Hall-Sensor entlang einer Linie III-III in Figur 2, Figur 4 einen Schnitt durch den erfindungsgemäßen Bauteilhalter mit Hall-Sensor entlang einer Linie IV-IV in Figur 2, Figur 5 eine Unteransicht des erfindungsgemäßen Bauteilhalters mit Hall-Sensor, Figur 6 einen Ausschnitt eines mit einem Hall-Sensor bestückten Gurts mit und ohne erfindungsgemäßen Bauteilhalter, Figur 7 eine perspektivische Darstellung des Bauteilhalters mit Hall-Sensor nach einem zweiten erfindungsgemäßen Ausführungsbeispiel, Figur 8 eine Vorderansicht des erfindungsgemäßen Bauteilhalters mit Hall-Sensor nach Figur 7, Figur 9 einen Schnitt durch den erfindungsgemäßen Bauteilhalter mit Hall-Sensor entlang einer Linie IX-IX in Figur 8, Figur 10 eine Rückansicht des erfindungsgemäßen Bauteilhalters mit Hall-Sensor nach Figur 7.

### Beschreibung der Ausführungsbeispiele

In Figur 1 ist in perspektivischer Darstellung ein Bauteilhalter 1 mit einem Hall-Sensor 2 nach einem ersten erfindungsgemäßen Ausführungsbeispiel dargestellt. Der Hall-Sensor 2 dient beispielsweise bekanntermaßen zur Positionserfassung der Drehlage eines in Figuren 3, 4 und 9 gestrichelt angedeuteten Rotors 5. Der Rotor 5 ist Bestandteil eines nicht näher dargestellten Verstellmotors, wie er zum Beispiel für Fensterhebemotoren oder als Schiebedachantrieb für Kraftfahrzeuge Verwendung findet. Der Rotor 5 besitzt an seinem Umfang verteilt nicht näher dargestellte Magnetringe, die vorzugsweise mehrpolig permanent magnetisierte Bereiche aufweisen. Im Zusammenwirken der magnetisierten Bereiche des Rotors 5 mit dem Hall-Sensor 2 läßt sich in bekannter Weise die Drehlage des Rotors 5 bestimmen.

Derartige Hall-Sensoren 2 haben ein im wesentlichen quaderförmiges Gehäuse 12. Wie in Figur 5, einer Unteransicht des Bauteilhalters 1 mit Hall-Sensor 2, dargestellt ist, besitzt der Hall-Sensor 2 drei Anschlußbeinchen 8, 9, 10. Die Anschlußbeinchen 8, 9, 10 stehen von dem Gehäuse 12 des Hall-Sensors 2 im wesentlichen rechtwinklig ab und verlaufen danach mehr oder weniger stark abgewinkelt, teilweise versetzt zu einer dem Rotor 5 zugewandten Sensorseite 3 des Hall-Sensors 2 und von dieser Sensorseite 3 fortführend, wie es zum Beispiel in Figur 3, einem Schnitt durch den Bauteilhalter 1 mit Hall-Sensor 2 entlang einer Linie III-III in Figur 2, die eine Vorderansicht des Hall-Sensors 2 mit Bauteilhalter 1 zeigt, näher dargestellt ist. Wie es auch in Figur 4, einem Schnitt durch den Bauteilhalter 1 mit Hall-Sensor 2 entlang einer Linie IV-IV in Figur 2, dargestellt ist, sind die zur elektrischen Verbindung mit einer Leiterplatte 15 vorgesehenen Anschlußbeinchen 8, 9, 10 in ihrem abgewinkelten Bereich in den aus Kunststoff bestehenden Bauteilhalter 1 eingebettet. Der Bauteilhalter 1 besteht im wesentlichen aus einem quaderförmig ausgebildeten Teil 22, der sich von einer der Leiterplatte 15 zugewandten Unterfläche 18 des Hall-Sensors 2 bis in die Nähe einer Oberfläche 20 der Leiterplatte 15 erstreckt. Ein in den Figuren 1, 3 und 5 sichtbares, einstückig am Bauteilhalter 1 zum Beispiel zylindrisch ausgebildetes weiteres Teil 23 am Bauteilhalter 1 dient als Abstandshalter, der im montierten Zustand des Bauteilhalters 1 an der Oberfläche 20 der Leiterplatte 15 anliegt.

Der Bauteilhalter 1 wird mittels in Figur 6 angedeuteter Spritzwerkzeuge 28 an die Anschlußbeinchen 8, 9, 10 angespritzt, die hierzu den Hall-Sensor 2 am Gehäuse 12 und im gehäusenahen Bereich der Anschlußbeinchen 8, 9, 10 umschließen. Wie in Figur 4 näher dargestellt ist, sind am quaderförmigen Teil 22 des Bauteilhalters 1 beispielsweise zwei zylindrisch ausgebildete Zentrierzapfen 25 mit konisch verjüngenden Enden 26 vorgesehen. Die Zentrierzapfen 25 stehen vom quaderförmigen Teil 22 des Bauteilhalters 1 etwa rechtwinklig ab. Die Anschlußbeinchen 8, 9, 10 weisen einen etwa rechtwinklig von der Unterfläche 18 des Hall-Sensors 2 abstehenden ersten Abschnitt 35 auf, der in einen zur Oberfläche 20 der Leiterplatte 15 parallel oder etwas schräg zur Oberfläche 20 verlaufenden zweiten Abschnitt 36 übergeht, um anschließend in einem in etwa parallel zu den Zentrierzapfen 25 und quer zur Oberfläche 20 der Leiterplatte 15 verlaufenden Endabschnitt 37 überzugehen. Vorzugsweise sind die Abschnitte 35 und 36 vollständig und der Endabschnitt 37 nur teilweise in den Kunststoff des Bauteilhalters 1 eingebunden. Die Zentrierzapfen 25 weisen quer zur Oberfläche 20 der Leiterplatte 15 eine etwas längere Erstreckung auf als die Anschlußbeinchen 8, 9, 10. Zwischen den beiden Zentrierzapfen 25 verläuft das Anschlußbeinchen 8, welches, wie in Figur 5 gezeigt ist, mit den beiden anderen Anschlußbeinchen 8, 9, 10 beispielsweise ein Dreieck bildet und dessen Spitze darstellt.

Die Zentrierzapfen 25 dienen einerseits zur exakten Positionierung des Hall-Sensors 2 auf der in den Figuren 2, 3 und 4 dargestellten Leiterplatte 15 und andererseits zur Halterung des Bauteilhalters 1 mit dem Hall-Sensor 2 auf der Leiterplatte 15. Wie in der Figur 4 näher dargestellt ist, verfügt die Leiterplatte 15 über entsprechende Öffnungen 16 zur Aufnahme der Zentrierzapfen 25 sowie über drei weitere Öffnungen 17 zur Aufnahme der Anschlußbeinchen 8, 9, 10.

Das Umspritzen des Bauteilhalters 1 kann beispielsweise derart erfolgen, daß, wie in Figur 6 dargestellt ist, der Hall-Sensor 2 zunächst ohne Bauteilhalter 1 mit seinen Anschlußbeinchen 8, 9, 10 an einem Gurt 27 vorliegt. Derartige, mit einer Vielzahl von Hall-Sensoren 2 bestückte Gurte 27 sind in der Massenherstellung bei Bestückungsautomaten üblicherweise vorgesehen, um die auf den Gurten 27 angebrachten, elektrischen Bauteile über nicht näher dargestellte Montagemittel an die Leiterplatte 15 anzubringen. Mittels der in Figur 6 angedeuteten Spritzwerkzeuge 28 kann der Bauteilhalter 1 an die am Gurt 27 befestigten Hall-Sensoren 2 einfach angespritzt werden, so daß in einem weiteren Arbeitsschritt über nicht näher dargestellte Montagemittel die Bestückung an die Leiterplatte 15 erfolgen kann. Denkbar ist aber auch, den Bauteilhalter 1 ohne Gurt 27 an den Hall-Sensor 2 anzuspritzen, um über nicht näher dargestellte Rüttelautomaten die Zufuhr zu dem Bestückungsautomat zu ermöglichen.

In den Figuren 7 bis 10 ist ein zweites Ausführungsbeispiel dargestellt, wobei alle gleichen oder gleichwirkenden Teile mit denselben Bezugszeichen des ersten Ausführungsbeispiels gemäß Figuren 1 bis 6 gekennzeichnet sind. Wie besonders deutlich in Figur 9, einem Schnitt durch den Bauteilhalter 1 mit Hall-Sensor 2 entlang einer Linie IX-IX in einer Vorderansicht auf den Bauteilhalter 1 mit Hall-Sensor 2 gemäß Figur 8, dargestellt ist, ist es auch möglich, zusätzlich zur teilweisen Umspritzung der Anschlußbeinchen 8, 9, 10 auch Bereiche des Gehäuses 12 des Hall-Sensors 2 mit in den Kunststoff des Bauteilhalters 1 einzuspritzen. Damit läßt sich eine weitere Stabilisierung des Hall-Sensors 2 in seiner Position im Bauteilhalter 1 erreichen, so daß eine besonders genaue Ausrichtung seiner im wesentlich quer zur Oberfläche 20 der Leiterplatte 15 verlaufenden, größtenteils kunststofffreien Sensorseite 3 möglich ist. Eine der Sensorseite 3 gegenüberliegende Sensorseite 4 des Hall-Sensors 2 ist größtenteils mit Kunststoff bedeckt, wobei eine Öffnung 30 im Kunststoff des Bauteilhalters 1 eine Verbindung der Sensorseite 4 des Hall-Sensors 2 mit der Umgebung schafft. Denkbar ist aber auch, die Sensorseite 4 des Hall-Sensors 2 vollständig mit Kunststoff zu bedecken. Wie in Figur 10, einer Seitenansicht der größtenteils kunststofffreien Sensorseite 3 des Hall-Sensors 2, gezeigt ist, kann dieser an seinem Außenrand noch teilweise von einem Kunststoffrand 40 des Bauteilhalters 1 umrahmt sein.

Wie in Figur 9 dargestellt ist, können die beispielsweise im zweiten Ausführungsbeispiel als Vierkant ausgebildeten Zentrierzapfen 25 über Rastmittel verfügen, die beispielsweise an jeweils zwei gegenüberliegenden Seiten des Vierkants des Zentrierzapfens 25 angeformt sind. Das Rastmittel ist dabei zum Beispiel in Form einer klappenähnlichen Verdickung 24 ausgebildet, die sich zum freien Endes 26 des Zentrierzapfens 25 hin verjüngt, um beim Einführen des Zentrierzapfens 25 in die Öffnung 16 der Leiterplatte 15 elastisch verformt zu werden, so daß nach dem vollständigen Einführen eine Hinterrastung der Verdickung 24 an einer dem Bauteilhalter 1 abgewandten Unterfläche 21 der Leiterplatte 15 erfolgt.

Möglich ist aber auch, bei dem gemäß dem ersten Ausführungsbeispiel zylindrisch ausgebildeten Zentrierzapfen 25 das Rastmittel in Form einer umlaufenden, zum freien Ende 26 des Zentrierzapfens 25 hin sich verjüngenden, in Figur 4 strichpunktiert angedeuteten Wulst 32 auszubilden, die ebenfalls durch Hinterrasten an der Unterfläche 21 der Leiterplatte 15 eine Halterung des Bauteilhalters 1 an der Leiterplatte 15 ermöglicht. Denkbar sind aber auch anders gestaltete Rastmittel, wie an den Zentrierzapfen 25 vorgesehene Rasthaken oder dergleichen. Möglich ist natürlich auch, die Rastmittel nicht an den Zentrierzapfen 25 vorzusehen, sondern zum Beispiel an dem quaderförmigen Teil 22 des Bauteilhalters 1.

## Patentansprüche

1. Bauteilhalter (1) für einen Hall-Sensor (2), wobei der Bauteilhalter aus Kunststoff besteht und zur Anordnung des Hall-Sensors an einer Leiterplatte (15) zumindest einen Zentrierzapfen (25) besitzt, wobei Anschlußbeinchen (8, 9, 10) zur elektrischen Kontaktierung von einem Gehäuse (12) des Hall-Sensors (2) abstehen, **dadurch gekennzeichnet, daß** der Bauteilhalter (1) nur an die Anschlußbeinchen (8, 9, 10) des Hall-Sensors (2) angespritzt ist.

2. Bauteilhalter (1) für einen Hall-Sensor (2), wobei der Bauteilhalter aus Kunststoff besteht und zur Anordnung des Hall-Sensors an einer Leiterplatte (15) zumindest einen Zentrierzapfen (25) besitzt, wobei Anschlußbeinchen (8, 9, 10) zur elektrischen Kontaktierung von einem Gehäuse (12) des Hall-Sensors (2) abstehen, **dadurch gekennzeichnet, daß** der Bauteilhalter (1) an die Anschlußbeinchen (8, 9, 10) und wenigstens teilweise an dem Gehäuse (12) des Hall-Sensors (2) angespritzt ist.

3. Bauteilhalter nach Anspruch 1 oder 2, **dadurch gekennzeichnet, daß** abgewinkelt ausgebildete Abschnitte (35, 36) der Anschlußbeinchen (8, 9, 10) vollständig vom Kunststoff des Bauteilhalters (1) umgeben sind.

4. Bauteilhalter nach Anspruch 1 oder 2, **dadurch gekennzeichnet, daß** der zumindest eine Zentrierzapfen (25) über ein Rastmittel (24) zur Verrastung an der Leiterplatte (15) verfügt.

5. Bauteilhalter nach Anspruch 4, **dadurch gekennzeichnet, daß** das Rastmittel in Form eine Verdickung (24) am zumindest einen Zentrierzapfen (25) ausgebildet ist, die sich zu einem freien Ende (26) des zumindest einen Zentrierzapfens (25) hin verjüngt.

6. Bauteilhalter nach Anspruch 2, **dadurch gekennzeichnet, daß** eine einem Rotor (5) eines Motors zugewandte Sensorseite (3) des Hall-Sensors (2) größtenteils ohne Kunststoffbedeckung des Bauteilhalters (1) ist.

7. Bauteilhalter nach Anspruch 2, **dadurch gekennzeichnet, daß** eine einem Rotor (5) eines Motors abgewandte Sensorseite (4) des Hall-Sensors (2) größtenteils von Kunststoff des Bauteilhalters (1) bedeckt ist.

8. Bauteilhalter nach Anspruch 1 oder 2, **dadurch gekennzeichnet, daß** das Gehäuse (12) des Hall-Sensors (2) eine quaderförmige Gestalt hat.

9. Verfahren zum Herstellen eines Bauteilhalters für einen Hall-Sensor nach Anspruch 1 oder 2, **dadurch gekennzeichnet, daß** ein Gurt (27) vorgesehen ist, an welchem Anschlußbeinchen (8, 9, 10) des Hall-Sensors (2) befestigt sind sowie zu dem Gurt (27) sich das Gehäuse (12) des Hall-Sensors (2) beabstandet befindet, und der Gurt (27) derart einem Kunststoff-Spritzwerkzeug (28) zugeführt wird, daß das Spritzwerkzeug (28) den Hall-Sensor (2) zumindest teilweise am Gehäuse (12) und an den Anschlußbeinchen (8, 9, 10) umschließt und daß durch Einführung von plastifiziertem Kunststoff in das Spritzwerkzeug (28) der Bauteilhalter (1) am Hall-Sensor (2) angespritzt wird.

## Claims

1. Component holder (1) for a Hall sensor (2), the component holder consisting of plastic and having at least one centring pin (25) for the arrangement of the Hall sensor on a printed circuit board (15), with terminal legs (8, 9, 10) for electrical contacting protruding from a housing (12) of the Hall sensor (2), **characterized in that** the component holder (1) is injection-moulded only onto the terminal legs (8, 9, 10) of the Hall sensor (2).

2. Component holder (1) for a Hall sensor (2), the component holder consisting of plastic and having at least one centring pin (25) for the arrangement of the Hall sensor on a printed circuit board (15), with terminal legs (8, 9, 10) for electrical contacting protruding from a housing (12) of the Hall sensor (2), **characterized in that** the component holder (1) is injection-moulded onto the terminal legs (8, 9, 10) and at least partly onto the housing (12) of the Hall sensor (2).

3. Component holder according to Claim 1 or 2, **characterized in that** angled-away portions (35, 36) of the terminal legs (8, 9, 10) are completely surrounded by the plastic of the component holder (1).

4. Component holder according to Claim 1 or 2, **characterized in that** the at least one centring pin (25) has a snap-in means (24) for snap-in engagement on the printed circuit board (15).

5. Component holder according to Claim 4, **characterized in that** the snap-in means takes the form of a thickening (24) on at least one centring pin (25), which thickening tapers towards a free end (26) of the at least one centring pin (25).

6. Component holder according to Claim 2, **characterized in that** a sensor side (3), facing a rotor (5) of a motor, of the Hall sensor (2) is for the most part without a plastic covering of the component holder (1).

7. Component holder according to Claim 2, **characterized in that** a sensor side (4), facing away from a rotor (5) of a motor, of the Hall sensor (2) is for the most part covered by plastic of the component holder (1).

8. Component holder according to Claim 1 or 2, **characterized in that** the housing (12) of the Hall sensor (2) has a cuboidal shape.

9. Process for producing a component holder for a Hall sensor according to Claim 1 or 2, **characterized in that** a belt (27), on which terminal legs (8, 9, 10) of the Hall sensor (2) are attached, is provided and the housing (12) of the Hall sensor (2) is located at a distance from the belt (27), and the belt (27) is fed to a plastic injection mould (28) in such a way that the injection mould (28) encloses the Hall sensor (2) at least partly at the housing (12) and at the terminal legs (8, 9, 10) and **in that**, by introducing plasticized polymer into the injection mould (28), the component holder (1) is moulded onto the Hall sensor (2).

## Revendications

1. Support de composant (1) pour un capteur Hall (2), pour lequel le support de composant est composé de matière plastique et possède au moins un pivot de centrage (25) pour assurer le positionnement du capteur Hall sur une plaque conductrice (15), avec des bras de raccordement (8, 9, 10) partant électrique d'un boîtier (12) du capteur Hall (2) afin d'assurer le contact électrique.
**caractérisé en ce que**
le support de composant (1) n'est injecté que sur les bras de raccordement (8, 9, 10) du capteur Hall (2).

2. Support de composant (1) pour un capteur Hall (2), pour lequel le support de composant est composé de matière plastique et possède au moins un pivot de centrage (25) pour assurer le positionnement du capteur Hall sur une plaque conductrice (15), avec des bras de raccordement (8, 9, 10) partant d'un boîtier (12) du capteur Hall (2) afin d'assurer le contact électrique,
**caractérisé en ce que**
le support de composant (1) est injecté sur les bras de raccordement (8, 9 et 10) et au moins partiellement sur le boîtier (12) du capteur Hall (2).

3. Support de composant selon la revendication 1 ou 2.
**caractérisé en ce que**
des coupes déviées (35, 36) des bras de raccordement (8, 9, 10) sont entièrement entourées de la matière plastique du support de composant (1).

4. Support de composant selon la revendication 1 ou 2,
**caractérisé en ce qu'**
le pivot de centrage (25) dispose d'un moyen d'accrochage (24) pour l'accrocher sur la plaque conductrice (15).

5. Support de composant selon la revendication 4.
**caractérisé en ce que**
le moyen d'accrochage se présente sous forme de gonflement (24) sur au moins un pivot de centrage (25) qui se rétrécit en une extrémité libre (26) du pivot de centrage (25).

6. Support de composant selon la revendication 2,
**caractérisé en ce qu'**
un côté de capteur (3) du capteur Hall (2) tourné vers un rotor (5) de moteur est en grande partie non recouvert de matière, plastique au niveau du support de composant (1).

7. Support de composant selon la revendication 2,
**caractérisé en ce qu'**
un côté de capteur (4) du capteur Hall (2) opposé à un rotor (5) de moteur est en grande partie recouvert de matière plastique au niveau du support de composant (1).

8. Support de composant selon la revendication 1 ou 2,
**caractérisé en ce que**
le boîtier (12) du capteur Hall (2) se présente sous forme de parallélépipède.

9. Procédé de fabrication d'un support de composant pour un capteur Hall selon la revendication 1 ou 2,
**caractérisé en ce qu'**
on prévoit une sangle (27) sur laquelle sont fixés des bras de raccordement (8, 9, 10) du capteur Hall (2), de laquelle le boîtier (12) du capteur Hall (2) se trouve à une certaine distance, et cette sangle (27) est amenée à l'outil d'injection plastique (28) de telle façon que l'outil d'injection (28) entoure le capteur Hall (2) au moins partiellement sur le boîtier (12) et sur les bras de raccordement (8, 9, 10) et que l'introduction d'une matière plastifiée dans l'outil (28), injecte le support de composant (1) sur le capteur Hall (2).
